(19) Europäisches Patentamt
European Patent Office
Office européen des brevets

(11) **EP 2 165 189 B1**

(12) **EUROPEAN PATENT SPECIFICATION**

(45) Date of publication and mention
of the grant of the patent:
**28.11.2012 Bulletin 2012/48**

(51) Int Cl.:
*G01R 33/04* *(2006.01)*       *G01R 33/18* *(2006.01)*
*G01R 33/06* *(2006.01)*       *G01N 27/72* *(2006.01)*
*G01N 33/543* *(2006.01)*      *G01N 27/74* *(2006.01)*

(21) Application number: **08778131.6**

(22) Date of filing: **08.07.2008**

(86) International application number:
**PCT/JP2008/062660**

(87) International publication number:
**WO 2009/008533 (15.01.2009 Gazette 2009/03)**

(54) **MAGNETIC DETECTION ELEMENT AND DETECTING METHOD**

MAGNETISCHES NACHWEISELEMENT UND NACHWEISVERFAHREN

ÉLÉMENT DE DÉTECTION MAGNÉTIQUE ET PROCÉDÉ DE DÉTECTION

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **09.07.2007 JP 2007179635**

(43) Date of publication of application:
**24.03.2010 Bulletin 2010/12**

(73) Proprietor: **Canon Kabushiki Kaisha
Tokyo 146-8501 (JP)**

(72) Inventor: **UEDA, Miki
Tokyo 146-8501 (JP)**

(74) Representative: **Weser, Wolfgang
Weser & Kollegen
Patentanwälte
Radeckestrasse 43
81245 München (DE)**

(56) References cited:
WO-A-01/40790        WO-A-2007/014322
WO-A-2007/042958     DE-A1- 10 035 600
US-A- 3 643 155      US-A1- 2005 244 987
US-B1- 6 736 978

• CHIRIAC H ET AL: "Magnetic GMI sensor for detection of biomolecules" JOURNAL OF MAGNETISM AND MAGNETIC MATERIALS, ELSEVIER SCIENCE PUBLISHERS, AMSTERDAM, NL, vol. 293, no. 1, 1 May 2005 (2005-05-01), pages 671-676, XP004883046 ISSN: 0304-8853 cited in the application

• ANDO B ET AL: "RTD Fluxgate performance for application in magnetic label-based bioassay: preliminary results" ENGINEERING IN MEDICINE AND BIOLOGY SOCIETY, 2006. EMBS '06. 28TH ANNUAL INTERNATIONAL CONFERENCE OF THE IEEE, IEEE, PISCATAWAY, NJ, USA, 30 August 2006 (2006-08-30), pages 5060-5063, XP031236665 ISBN: 978-1-4244-0032-4

• TANG J ET AL: "Giant magnetoresistance, structural and magnetic properties of glass-coated Fe-Ni-Cu microwires" JOURNAL OF MAGNETISM AND MAGNETIC MATERIALS, ELSEVIER SCIENCE PUBLISHERS, AMSTERDAM, NL, vol. 249, no. 1-2, 1 August 2002 (2002-08-01), pages 73-78, XP004389890 ISSN: 0304-8853

• ANDO ET AL: "''Residence times difference'' fluxgate" MEASUREMENT, INSTITUTE OF MEASUREMENT AND CONTROL. LONDON, GB, vol. 38, no. 2, 1 September 2005 (2005-09-01), pages 89-112, XP005029251 ISSN: 0263-2241

• CARMAN G P ET AL: "Dynamic Magnetomechanical Behavior of Terfenol-D/ Epoxy 1-3 Particulate Composites" IEEE TRANSACTIONS ON MAGNETICS, IEEE SERVICE CENTER, NEW YORK, NY, US, vol. 40, no. 1, 1 January 2004 (2004-01-01), pages 71-77, XP011106756 ISSN: 0018-9464

EP 2 165 189 B1

- RICHARDSON J ET AL: "A novel measuring system for the determination of paramagnetic particle labels for use in magneto-immunoassays" BIOSENSORS & BIOELECTRONICS, ELSEVIER SCIENCE PUBLISHERS, BARKING, GB, vol. 16, no. 9-12, 1 December 2001 (2001-12-01), pages 1127-1132, XP002334352 ISSN: 0956-5663 cited in the application
- FERREIRA H A ET AL: "Biodetection using magnetically labeled biomolecules and arrays of spin valve sensors (invited)" JOURNAL OF APPLIED PHYSICS, AMERICAN INSTITUTE OF PHYSICS. NEW YORK, US, vol. 93, no. 10, 15 May 2003 (2003-05-15), pages 7281-7286, XP012058127 ISSN: 0021-8979 cited in the application
- CARR C ET AL: "Magnetic Sensors for Bioassay: HTS SQUIDs or GMRs?" IEEE TRANSACTIONS ON APPLIED SUPERCONDUCTIVITY, IEEE SERVICE CENTER, LOS ALAMITOS, CA, US, vol. 17, no. 2, 1 June 2007 (2007-06-01), pages 808-811, XP011188120 ISSN: 1051-8223
- BESSE PIERRE-A ET AL: "Detection of a single magnetic microbead using a miniaturized silicon Hall sensor" APPLIED PHYSICS LETTERS, AIP, AMERICAN INSTITUTE OF PHYSICS, MELVILLE, NY, vol. 80, no. 22, 3 June 2002 (2002-06-03), pages 4199-4201, XP012031095 ISSN: 0003-6951 cited in the application
- LEE SEUNGKYUN ET AL: "Magnetic gradiometer based on a high-transition temperature superconducting quantum interference device for improved sensitivity of a biosensor" APPLIED PHYSICS LETTERS, AIP, AMERICAN INSTITUTE OF PHYSICS, MELVILLE, NY, vol. 81, no. 16, 14 October 2002 (2002-10-14), pages 3094-3096, XP012032234 ISSN: 0003-6951 cited in the application
- PHAN ET AL: "Giant magnetoimpedance materials: Fundamentals and applications" PROGRESS IN MATERIALS SCIENCE, PERGAMON PRESS, GB, vol. 53, no. 2, 1 February 2008 (2008-02-01), pages 323-420, XP022492050 ISSN: 0079-6425

**Description**

TECHNICAL FIELD

The present invention relates to a magnetic detection element and a detecting method for detecting magnetic particles, or detecting nonmagnetic substances by using magnetic particles as labels.

BACKGROUND ART

As a quantitative immunoassay, a radio immunoassay (RIA: radio immunoassay or IRMA: immunoradiometric assay) has been conventionally known. In this method, a competitive antigen or antibody is labeled with a radionuclide, and from the measurement result of specific radioactivity, the antigen is quantitatively measured. Specifically, a target substance such as an antigen is labeled, and is indirectly measured. This method provides high sensitivity, and has significantly contributed to clinical diagnoses. However, it is necessary to consider safety of nuclides, and exclusive-use facilities and equipment are required. Thus, as the methods which are easily handled, methods using labels such as, for example, fluorescent substances, enzymes, electrochemical luminescent molecules and magnetic particles have been proposed.

In the case of using a fluorescent label, an enzyme label, or an electrochemical luminescent label as a label, the label is used for an optical measurement method, and a target substance is detected by measuring absorptivity and transmittance of light or a light emitting quantity. An enzyme immunoassay (EIA: Enzyme Immunoassay) using an enzyme for a label is the method in which after antigen-antibody reaction is caused, an enzyme-labeled antibody is reacted, a substrate for the enzyme is added to develop color, and colorimetric determination is performed according to the absorbance.

Further, the research reports of the biosensors which indirectly detect biological molecules by magnetic sensor elements by using magnetic particles as labels are made by several research institutions. Various magnetic sensor elements are cited as the magnetic sensor element used for the detecting method. Those using magnetoresistive effect elements, Hall elements, Josephson elements, coils, elements in which magnetic impedances change, and a flux gate (FG) sensor are proposed (Japanese Patent Application Laid-Open No. 2005-315744 and Japanese Patent Application Laid-Open No. 2006-208368, and H. A. Ferreira, et al., J. Appl. Phys., 93 7281 (2003), Pierre-A. Besse, et al., Appl. Phys. Lett. 80 4199 (2002), SeungKyun Lee, et al., Appl. Phys. Lett. 81 3094 (2002), Richard Luxton, et al., Anal. Chem. 16 1127 (2001), and Horia Chiriac, et al., J. Magn. Magn. Mat. 293 671 (2005). An FG sensor detects induced electromotive force by using a soft magnetic substance and a coil. The detecting methods of biological substances using these elements respectively have the characteristics. Above all, the FG sensor has the advantages of having high dissolution of a magnetic field, high linearity of the output with respect to the input magnetic field, and high temperature stability.

FG sensor elements are broadly separated into two types, a parallel type and an orthogonal type.

An orthogonal FG sensor generally has a magnetic film, a unit for applying an alternating magnetic field to the magnetic film, and a detecting coil for detecting a magnetization change of the magnetic film. A magnetic field is detected through the induced electromotive force of the detecting coil which is caused by a magnetization change of the magnetic film in the alternating magnetic field Hac (The Transactions of the Institute of Electrical Engineers of Japan C, Vol. 93-C, No. 2, P.27 (1973), and Foundation and Application of Electromagnetics, the Institute of Electrical Engineers of Japan, Magnetics Technical Committee, p.171).

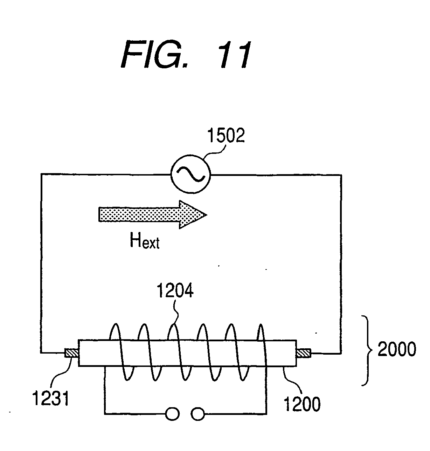

FIG. 11 is a view illustrating a constitution example of an ordinary orthogonal FG sensor element. An FG sensor element 2000 has an exciting conductor 1231 connected to an alternating-current power supply 1502, a magnetic film 1200 provided on a circumferential surface of the exciting conductor 1231, and a detecting coil 1204 wound on a cylinder constituted of the magnetic film 1200. The operation principle of the FG sensor element in which an easy axis of magnetization of the magnetic film 1200 corresponds to the direction of the alternating magnetic field will be briefly described hereinafter.

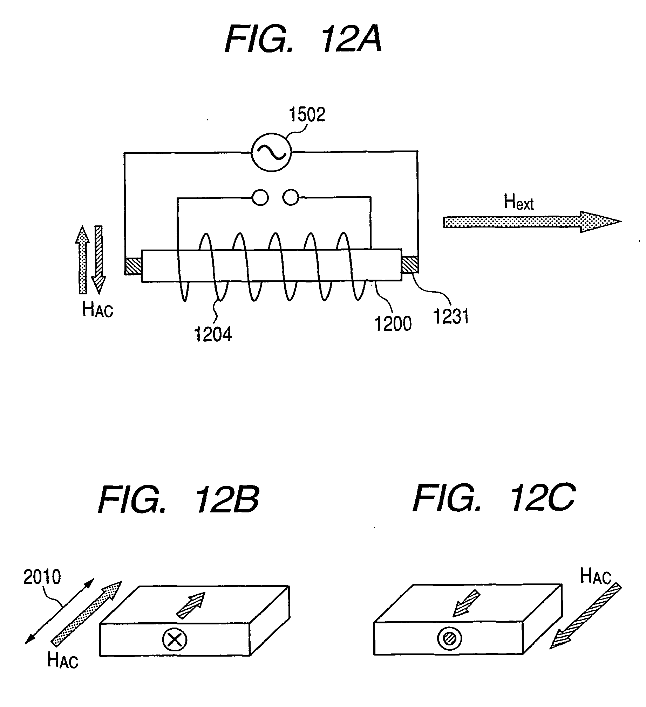

FIGS. 12A to 12C are views for describing the operation principle of the FG sensor element illustrated in FIG. 11.

In FIG. 12A, the direction of the detectable magnetic field is the longitudinal direction of the detecting coil. Here, as in FIG. 12A, the FG sensor element 2000 illustrated in FIG. 11 is placed in an external magnetic field (magnetic field to be detected) Hext. The direction of the magnetic field by the external magnetic field is the longitudinal direction of the detecting coil 1204. Further, an alternating magnetic field Hac is applied into the surface of the cylindrical magnetic thin film 1200 via the exciting conductor 1231 by the alternating-current power supply 1502. Here, the alternating magnetic field Hac is assumed to have enough intensity to saturate magnetization of the magnetic film 1200 and have a frequency sufficiently higher than the frequency at which a domain wall displacement phenomenon occurs.

For simplification, as illustrated in FIGS. 12B and 12C, the magnetic film 1200 is viewed by being cut and developed to be a plane. An easy axis of magnetization 2010 illustrated in FIG. 12B is also in the same direction in FIG. 12C. The alternating magnetic field Hac occurs parallel with the easy axis of magnetization. The relationship of magnetization of the magnetic film 1200 and the alternating magnetic field is the reciprocating movement between the state of FIG. 12B and the state of FIG. 12C. The magnetization behavior of the magnetic film 1200 is such that magnetization is saturated in the Hac direction in each of the cases of FIGS. 12B and 12C.

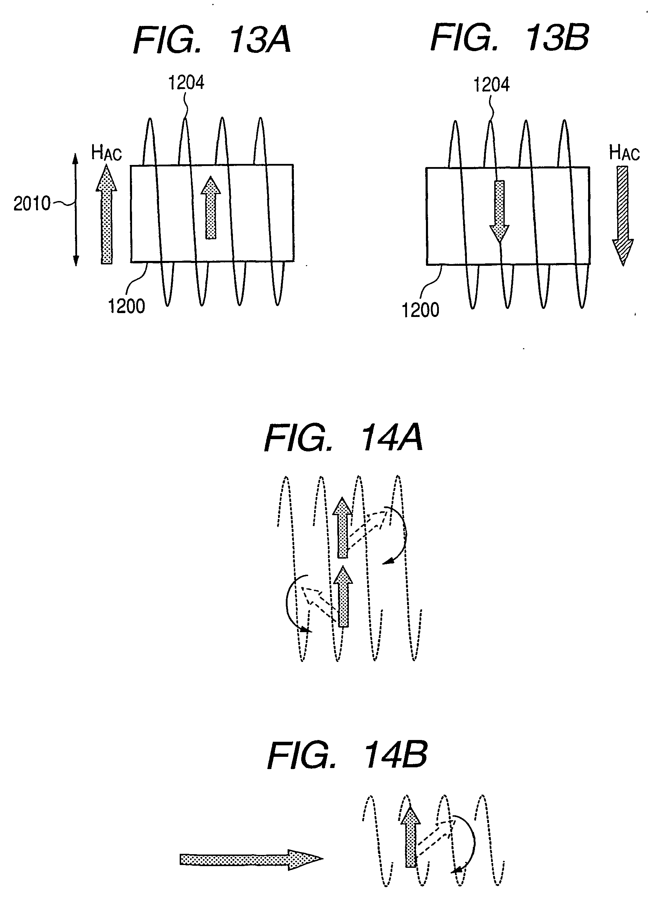

Therefore, a change with time of the magnetization inside the detecting coil 1204 following the magnetization change is as in FIGS. 13A and 13B. The easy axis of magnetization 2010 illustrated in FIG. 13A is also in the same direction in FIG. 13B. As illustrated in FIGS. 13A and 13B, the film thickness of the magnetic film is formed to be sufficiently thin with respect to the circular cylinder radius of the cylinder on which the magnetic film is formed, and magnetization changes with time in the mode of rotating inside the film.

When the external magnetic field (detection field) is zero, as illustrated in FIG. 14A, clockwise magnetization rotation and counterclockwise magnetization rotation in the drawing exist in equal ratio, and therefore, the induced electromotive force of the detecting coil 1204 becomes zero.

On the other hand, when the external magnetic field (detection magnetic field) exists, as shown in FIG. 14B, the abundance ratio of the magnetization rotating via the direction of the detection magnetic field becomes high. Thus, a magnetization change in the lengthwise direction occurs in the detecting coil, and induced electromotive force occurs to the detecting coil. Further, when the detection magnetic field is large, the excitation phase angle at the start of reversal of magnetization becomes small, and therefore, both elements of the direction and magnitude of the detection magnetic field can be read. The magnetic field intensity can be detected from the difference between the phase of the excitation magnetic field and the phase of the induced electromotive force occurring to the detecting coil. The direction of the magnetic field reflects on the sign of the above described induced electromotive force.

As the orthogonal FG sensor, there are the ones differing from the above describe structure, such as the one in which the easy axis of magnetization of the magnetic film differs from the above description, the one having the structure in which the magnetic film and the exciting copper wire are integrated, and the one with a strip-shaped core. However, with any type of FG sensor, the operation principle is similar to the aforementioned content.

DISCLOSURE OF THE INVENTION

Magnetic field measurement by the orthogonal FG sensor element is performed with an electric circuit having the cylindrical magnetic film 1200, the exciting conductor 1231 penetrating through the center of the cylindrical magnetic film 1200 and the detecting coil 1204 as seen in The Transactions of the Institute of Electrical Engineers of Japan C, Vol. 93-C, No. 2, P.27 (1973), and Foundation and Application of Electromagnetics, the Institute of Electrical Engineers of Japan, Magnetics Technical Committee, p.171. As described above, an alternating current is passed into the exciting conductor 1231, and the influence which is exerted on the magnetization change in the magnetic film 1200 by the detected magnetic field is detected through the induced electromotive force which occurs to the detecting coil 1204. Therefore, when the presence and absence of the occurrence of induced electromotive force, or the outputs of the sensor before and after the magnetic particle is fixed are compared, the magnetic particle can be detected through the magnetic field (called $H_s$) which the magnetic particle makes around the magnetic particle.

When such a local magnetic field $H_s$ as the magnetic particle makes is to be detected by using an orthogonal FG sensor element, if the positional relationship of the magnetic particle and the detecting coil 1204 changes, the change may significantly influence the output of the sensor element. If mutual cancellation occurs to the induced electromotive force of the sensor element, the sensor output significantly reduces. Therefore, depending on the conditions, there arises the situation in which detection of the magnetic particle is difficult, such as the situation in which the sensor output cannot be sufficiently obtained although the magnetic particle 1401 exists.

The present invention is made to solve the problem which the conventional art as describe above has, and has an object to provide a magnetic detection element and a detecting method which increase detection intensity of a magnetic field by an inspection target substance.

This object is achieved by the magnetic detection element according to claim 1 and the detecting method according to claim 5.

The other claims relate to further developments.

According to the present invention, when a magnetic particle, or a nonmagnetic particle labeled with a magnetic particle is detected, detection intensity of a magnetic field by the magnetic particle can be increased.

Further features of the present invention will become apparent from the following description of exemplary embodiments with reference to the attached drawings.

BRIEF DESCRIPTION OF THE DRAWINGS

FIG. 1 is a schematic view for describing the constitution of an FG sensor element of an embodiment.

FIG. 2 is a schematic view illustrating a constitution example of the FG sensor element illustrated in FIG. 1.

FIG. 3 is a schematic view illustrating an example when magnetic particles are fixed to the FG sensor element illustrated in FIG. 2.

FIGS. 4A and 4B are views for describing coordinates of the magnetic particles fixed to the FG sensor element.

FIGS. 5A, 5B, 5C and 5D are schematic views illustrating a magnetic field which an ordinary FG sensor element receives from the magnetic particles.

FIG. 6 is a schematic view illustrating another constitution example of the FG sensor element of the present embodiment.

FIG. 7 is a schematic view illustrating a constitution example of the FG sensor element illustrated in FIG. 6.

FIG. 8 is a schematic view illustrating an example when magnetic particles are fixed to the FG sensor element illustrated in FIG. 7.

FIG. 9 is a schematic view illustrating one example when the FG sensor element of the present embodiment is used by being incorporated into a casing.

FIG. 10 is a view illustrating a constitution example of an detection object substance of example 1.

FIG. 11 is a view illustrating a constitution example of an ordinary orthogonal FG sensor element.

FIGS. 12A, 12B and 12C are views for describing the operation principle of the FG sensor element illustrated in FIG. 11.

FIGS. 13A and 13B are schematic diagrams each illustrating the state of a change with time of a magnetic field in the FG sensor element illustrated in FIG. 11.

FIGS. 14A and 14B are schematic diagrams illustrating the states of the magnetic fields in the cases without an external magnetic field and with the external magnetic field in the FG sensor element illustrated in FIG. 11.

## BEST MODES FOR CARRYING OUT THE INVENTION

The constitution of a magnetic detection element of an embodiment will be described. In the present embodiment, the case in which the magnetic detection element is an orthogonal FG sensor element is described.

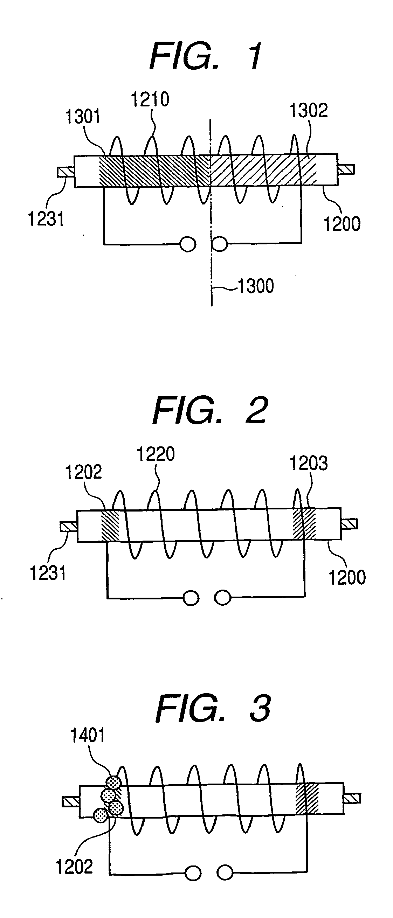

FIG. 1 is a schematic view for describing the constitution of the FG sensor element of the present embodiment. As shown in FIG. 1, the FG sensor element has an exciting conductor 1231, a magnetic film 1200 provided on an outer circumferential surface of the exciting conductor 1231, and a detecting coil 1210 wound around the magnetic film 1200. The detecting coil 1210 detects signals differing in intensity in accordance with the quantity of the magnetized detection object substance.

As the magnetic substance used for the magnetic film 1200, for example, a permalloy constituted of nickel (Ni) and iron (Fe), and a molybdenum permalloy constituted of Ni, Fe and molybdenum (Mo) are used.

In the FG sensor element of the present embodiment, the surface of the sensor element is divided into a region 1301 and a region 1302 by a section 1300 which divides the surface of the sensor element into two in the lengthwise direction of the detecting coil 1210. When the length of the detecting coil 1210 is set as L, the section 1300 corresponds to a position at L/2 from the end of the detecting coil 1210. The affinity with the detection object substance in at least a part of the region 1301 differs from that in at least a part of the region 1302. In this case, the detection object substance is a magnetic particle.

FIG. 2 is a schematic view illustrating a constitution example of the FG sensor element described with FIG. 1. On all or a part of the region 1301, a magnetic particle fixing film 1202 having a high affinity with the magnetic particle is formed. Further, in all or a part of the region 1302, a magnetic particle non-fixing film 1203 having a lower affinity with the magnetic particle as compared with the magnetic particle fixing film 1202 is formed. The magnetic particle fixing film 1202 and the magnetic particle non-fixing film 1203 are films constituted of nonmagnetic materials.

In the constitution example illustrated in FIG. 2, the magnetic particle fixing film 1202 is formed on the surface of the magnetic film 1200 at one end portion of the detecting coil 1220, and the magnetic particle non-fixing film 1203 is formed on the surface of the magnetic film 1200 at the other end portion of the detecting coil 1220. The magnetic particle fixing film 1202 is formed on a part of the region 1301, and the magnetic particle non-fixing film 1203 is formed on a part of the region 1302. However, the above described affinity may gradually change on the element surface from the region 1301 through the region 1302, or may locally differ as illustrated in FIG. 2.

As the method for forming the films, which have the properties different in affinity with the magnetic particle, on the surfaces of the regions 1301 and 1302 of the magnetic film 1200, at least any one of a sputtering method, a plating method and a vapor deposition method may be used. Depending on whether the films have a hydrophilic property or a hydrophobic property, the affinities of the films with the magnetic particle may be caused to differ. Further, even with use of the same kinds of films, by changing the film thicknesses of the films, the affinities of the films with the magnetic particle may be caused to differ. Further, by gradually changing the thickness or the composition of the film formed on the surface of the magnetic film 1200, the affinities with the magnetic particle may be changed between the regions 1301 and 1302.

For example, a material with a high affinity with the magnetic particle may be formed so as to obtain the largest film thickness in the region 1301. A partially large film thickness can be made by using a collimate sputtering method.

The affinity with the magnetic particle in each of the regions 1301 and 1302 is described, but the detection object substance is not limited to a magnetic particle, and may be a substance fixable to a magnetic particle. In the present embodiment, the region 1301 is described as having a higher affinity with the magnetic particle than the region 1302, but the properties of the regions 1301 and 1302 may be opposite.

FIG. 3 is a schematic view illustrating an example when the magnetic particles are fixed to the FG sensor element illustrated in FIG. 2. By preparing the above described orthogonal FG sensor element, a magnetic particle 1401 can be fixed to a part of the sensor element surface, as illustrated in the schematic view of FIG. 3. Here, the case in which a plurality of magnetic particles 1401 are fixed to the magnetic particle fixing film 1202 is illustrated.

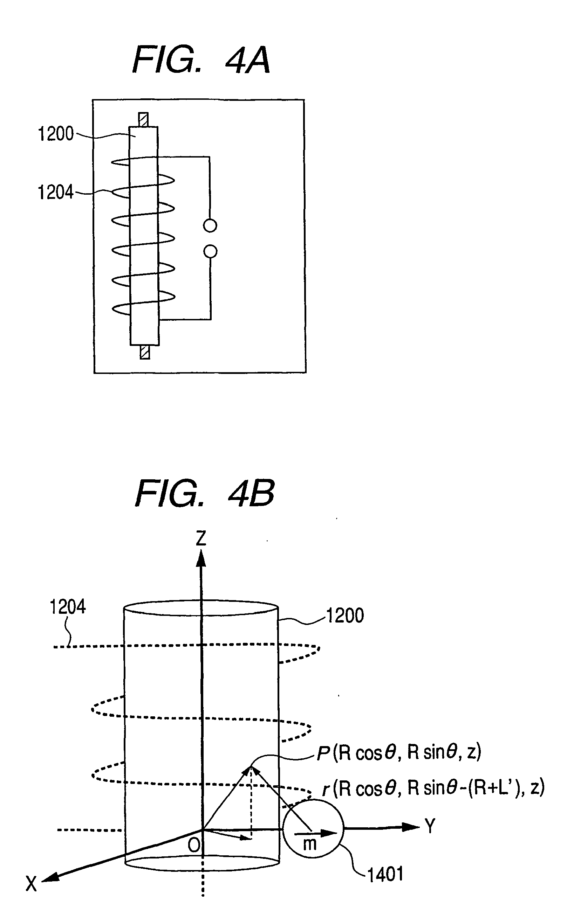

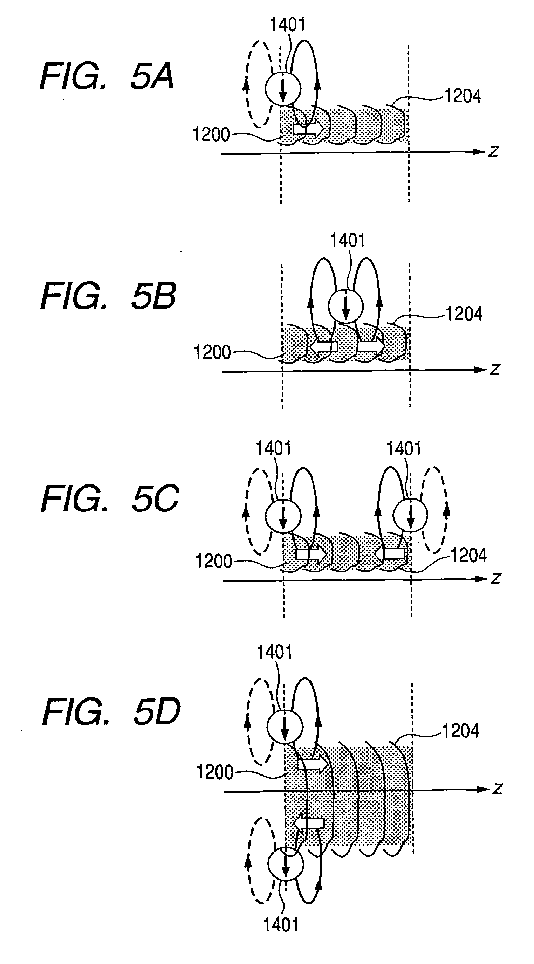

Next, in the case in which one magnetic particle 1401 having magnetization m (expressed in vector) is fixed onto the FG sensor element, the detection principle of the FG sensor element will be described by using FIGS. 4A and 4B and 5A to 5D.

FIGS. 4A and 4B are views for describing the coordinates of the magnetic particle fixed to the FG sensor element. FIGS. 5A to 5D are schematic diagrams each illustrating the magnetic field which an ordinary FG sensor element receives from the magnetic particle. White arrows in the lateral direction of FIGS. 5A to 5D each indicates a component in the detectable direction of a magnetic field $H_s$ (expressed in vector) from the magnetic particle. Magnetization of the magnetic particle has its direction fixed by a magnetic field applying unit (not illustrated) which applies a direct-current magnetic field in the direction perpendicular to the direction of an alternating magnetic field. The magnetic field applying unit which applies a direct-current magnetic field may be any unit as long as the unit can apply a desired magnetic field, and may be a permanent magnet or an electromagnet.

The FG sensor element in the part enclosed by the broken line of FIG. 4A is enlarged, and an arbitrary point P on the surface of the magnetic film 1200 is expressed by three-dimensional coordinates. In order to describe the case of an ordinary FG sensor element, the reference numeral of the detecting coil is set as 1204. FIG. $4_B$ is a view of an enlarged part of the FG sensor element illustrated in FIG. 4A. When the coordinates are defined, a circular cylindrical structure constituted of the exciting conductor 1231 and the magnetic film 1200 illustrated in FIG. 1 is considered.

As illustrated in FIGS. 4A and 4B, in order to express the arbitrary point P on the surface of the magnetic film 1200 by the three-dimensional coordinates, the straight line which is in the longitudinal direction of the above described circular cylindrical structure and passes through the center of the exciting conductor 1231 is set as a Z-axis, and a reference point O at which an X-axis and a Y-axis intersect each other on the Z-axis is determined. When a radius of the above described circular cylindrical structure is set as R, and an angle formed by the line segment, which is the result of projecting the straight line from the reference point O to the point P onto an XY-plane coordinates, from the X-axis is set as $\theta$, the coordinates of the point P are expressed by (Rcos$\theta$, Rsin$\theta$, z). When the radius of the magnetic particle 1401 located on the Y-axis in the drawing on the surface of the magnetic film 1200 is set as L', the vector of a distance r from the reference point O to the magnetic particle 1401 at the point P is expressed by (Rcos$\theta$, Rsin$\theta$-(R+L'), z). When the absolute permeability of vacuum is set at $\mu_0$, a floating magnetic field $H_s$ generated from the magnetic particle 1401 at the point P is expressed by Formula (1).

$$H_s = -\frac{1}{4\pi\mu_0 r^3}\left[m - \frac{3}{r^2}(mr)r\right] \quad \cdots\cdots\cdots\cdots\cdots (1)$$

Here, by solving Formula (1), the surface integral of the magnetic field intensity $|H_s(Z)|$ of a detectable component in the element longitudinal direction is taken, and the result is set as $H_s$ sum.

The case in which the magnetic particle 1401 is present near the end of the detecting coil 1204 of the FG element as illustrated in FIG. 5A is set as a state I. The case in which the magnetic particle 1401 is present in the vicinity of the center of the detecting coil 1204 as illustrated in FIG. 5B is set as a state II. Comparing the case of the state I and the case of the state II, the values of $H_s$ sum differ significantly. In the case of the state II, the magnetic field from the magnetic particle 1401 which the magnetic film 1200 receives is in the opposite direction with the section of the sensor element including the contact point of the magnetic particle 1401 and the sensor element as the boundary, as in FIG. 5B. Specifically, in the case of the state I, a high sensor element output is obtained, but in the case of the state II, the magnetic film 1200 receives the magnetic field $H_s$ in the opposite direction depending on the position of the magnetic particle 1401. At this time, in the region where the magnetic field $H_s$ in the opposite direction is exerted, reverse magnetization rotation occurs, and the induced electromotive force in the detecting coil 1204 occurs in the direction to cancel out each other. As a result, the sensor element output significantly attenuates.

Further, the case in which the magnetic particles 1401 are present at the positions (for example, both ends of the detecting coil illustrated in FIG. 5C) symmetrical with respect to the section dividing the detecting coil 1204 into two in the lengthwise direction is set as a state III. When a plurality of magnetic particles 1401 are to be detected as in the state III, it is found that the outputs from the regions where the $H_s$sum in the opposite direction are exerted cancel out each other as in the case of the state II. Further, it is found out that as in a state IV illustrated in FIG. 5D, when the magnetic particles are present at positions symmetrical about the center axis of the element (Z-axis), such as the back and front of the FG sensor element, for example, the outputs cancel out each other as in the above described states II and III.

Specifically, as the state becomes closer to the situation of the state II, III or IV, mutual cancellation of outputs increases when considering the entire element, and in spite of the presence of the magnetic particle, only a low output can be obtained.

From the consideration of the above described detection principle, detection of an entire magnetic field $H_s$ tot which the FG sensor element receives from the magnetic particle 1401 will be examined. As described with FIGS. 1 and 2, in the FG sensor element of the present embodiment, the regions 1301 and 1302 are set so that the magnetic particle 1401 attaches to the area near one end of the detecting coil 1210. Therefore, not only in the case of a single magnetic particle, but also in the case of a plurality of magnetic particles as illustrated in FIG. 3, the magnetic field of the magnetic particles can be detected in the above described state I. Therefore, it is found that in the FG sensor element of the present embodiment, a high output can be obtained with respect to the magnetic field by the magnetic particle.

In the present embodiment, the portion having a high affinity with the detection object substance is provided at least a part of one region when the detecting coil is divided into two. Therefore, when the magnetic field of the detection object substance is measured, the magnetic particle is fixed to the portion having a high affinity with the detection object substance, and the magnetic field by the magnetic particle is easily detected. Therefore, an output with high signal intensity corresponding to the magnetic field can be obtained.

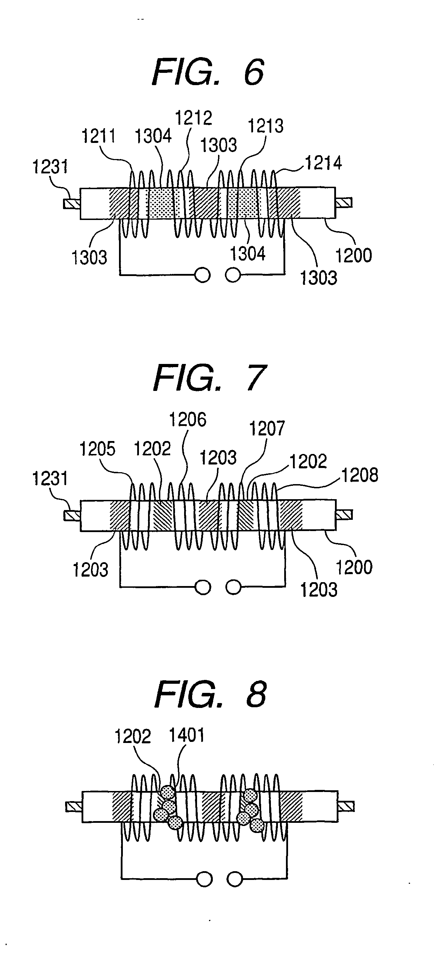

Next, another constitution example of the FG sensor element of the present embodiment will be described. FIG. 6 is a schematic view illustrating another constitution example of the FG sensor element of the present embodiment. The same components as in FIG. 1 are assigned with the same reference numerals, and the detailed description thereof will be omitted. Further, a magnetic particle is used as the detection object substance.

As illustrated in FIG. 6, the FG sensor element has the exciting conductor 1231, the magnetic film 1200, and detecting coils 1211, 1212, 1213 and 1214. The detecting coils 1211, 1212, 1213 and 1214 detect signals differing in intensity in accordance with the quantity of the magnetized detection object substance. The above described four detecting coils are connected in series, but the winding directions of the coils are alternately opposite to one another.

A region 1303 is set on the magnetic film 1200 at one end portion of the detecting coil 1211, and a region 1304 is set on the magnetic film 1200 at a connecting portion of the other end portion of the detecting coil 1211 and the detecting coil 1212. A region 1303 is set on the magnetic film 1200 at a connecting portion of the detecting coil 1212 and the detecting coil 1213, and a region 1304 is set on the magnetic film 1200 at a connecting portion of the detecting coil 1213 and one end portion of the detecting coil 1214. A region 1303 is set on the magnetic film 1200 at the other end portion of the detecting coil 1214.

In this manner, the regions 1303 and 1304 are alternately provided from the end portion of the coil on the magnetic film 1200 in the connecting portions of the two coils or more connected in series, and the end portions of the coil. The affinity with the detection object substance in the region 1303 differs from that of at least a part of the region 1304. The region 1303 corresponds to the first region of the present invention, and the region 1304 corresponds to the second region of the present invention.

FIG. 7 is a schematic view illustrating a constitution example of the FG sensor element described with FIG. 6.

The detecting coils 1205, 1206, 1207 and 1208 illustrated in FIG. 7 have the similar constitutions to the four detecting coils described with FIG. 6. The magnetic particle fixing film 1202 having a high affinity with the magnetic particle is formed on all or a part of the region 1303. The magnetic particle non-fixing film 1203 having a lower affinity with the magnetic particle as compared with the magnetic particle fixing film 1202 is formed on all or a part of the region 1304. In the constitution example illustrated in FIG. 7, the magnetic particle fixing film 1202 is formed on a part of the region 1303 illustrated in FIG. 6, and the magnetic particle non-fixing film 1203 is formed on a part of the region 1304. However, the above described affinity may be gradually changed on the element surface from the region 1301 through the region 1302, or may locally differ as illustrated in FIG. 7.

The affinity with the magnetic particle in each of the regions 1303 and 1304 is described, but the detection object substance is not limited to the magnetic particle, and may be a substance fixable to the magnetic particle. Further, hereinafter, the region 1303 will be described as having a higher affinity with the magnetic particle than the region 1304, but the properties of the regions 1303 and 1304 may be opposite.

In the FG sensor element illustrated in FIGS. 6 and 7, the detection intensity of the magnetic field by the magnetic particle increases more than the conventional sensor element in accordance with the operation principle described with FIG. 5A. In FIGS. 6 and 7, the case of the four detecting coils connected in series is described, but the number of detecting coils is not limited to four, and may be any number if only it is not smaller than two. Further, the adjacent detecting coils may overlay on the regions 1303 and 1304 set in the end portions of the coils and the boundaries of the coils.

FIG. 8 is a schematic view illustrating an example when the magnetic particles are fixed to the FG sensor element illustrated in FIG. 7. By preparing the above described orthogonal FG sensor element, the magnetic particle 1401 can be fixed to a part of the surface of the sensor element as illustrated in the schematic view of FIG. 8. Here, the case in which a plurality of magnetic particles 1401 are fixed to the magnetic particle fixing film 1202 is illustrated.

When the magnetic particle 1401 is actually detected, the situation similar to the above described calculation model can be realized by aligning the magnetic field of the magnetic particle 1401 in a fixed direction by applying an external magnetic field. By especially applying a static magnetic field in the direction of the element in which detection is difficult, the sensitivity saturation of the element is avoided. Above all, FIGS. 5A to 5D examine the case of applying the magnetic field in the normal line direction to the element contact plane in the fixed position of the detection object substance and the element. However, "the magnetic field in the direction in which detection is difficult" used in the description of the embodiment and examples which will be described later means the magnetic field having the components in the directions other than the detection direction, and "the magnetic field in the normal line direction" means the magnetic field having the component in the normal line direction. Further, "element surface" has the meaning also including the surface of the protection film and the like formed around the element.

By detecting the magnetic field of the magnetic particle 1401 in the situation close to the state I described with FIG. 5A, the magnetic particle 1401 can be detected with a high output of the sensor element. Further, even with a small number of magnetic particles 1401, a sufficient output can be obtained as compared with an ordinary method, and detection can be made.

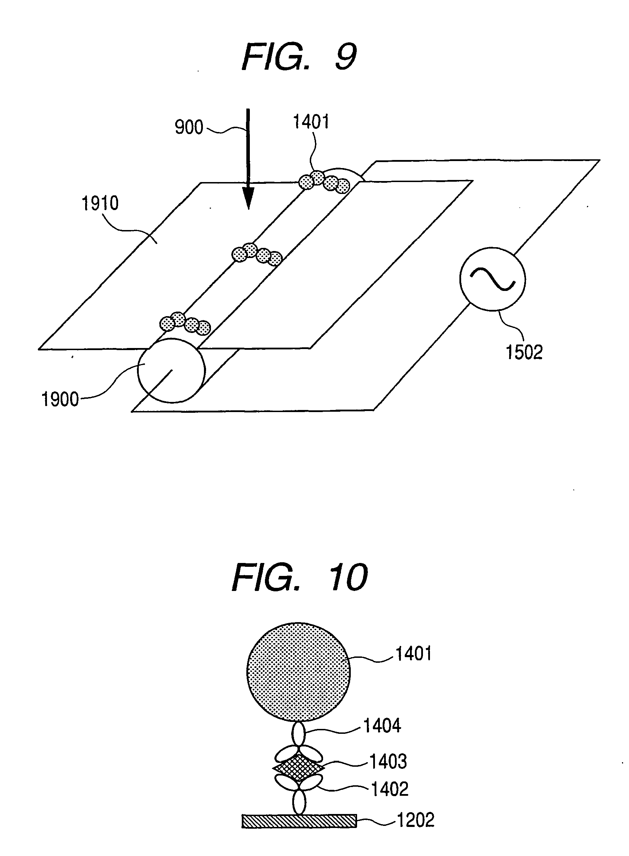

FIG. 9 is a schematic view illustrating an example of the case in which the FG sensor element of the present embodiment is used by being incorporated into a casing. As illustrated in FIG. 9, an FG sensor element 1900 connected to an alternating-current power supply 1502 is incorporated into the casing. A part of the FG sensor element 1900 is an opening provided in a casing surface 1910, and is protruded from the casing surface 1910. The magnetic particles 1401 are fixed to the magnetic particle fixing film on the portion protruded from the casing surface 1910 in the FG sensor element 1900.

Further, the static magnetic field for aligning the magnetizing direction of the magnetic particle 1401 is applied in a perpendicular direction 900 to the casing surface 1910. The magnetic field applying unit for the static magnetic field may be a permanent magnet or an electromagnet, or other units if only it can apply a desired magnetic field. In the case as illustrated in FIG. 9, the magnetic field can be detected with the conditions close to the state I described with FIG. 5A.

In the present embodiment, the detecting coil has the constitution in which two or more coils differing in the winding direction are connected in series, and the parts having a high affinity with the detection object substance and the parts having a low affinity are alternately provided on the connecting portions of the coils and the end portions of the coils at both ends of the detecting coil. Therefore, when the magnetic field of the detection object substance is measured, the magnetic particle is fixed to the parts having a high affinity with the detection object substance, and the magnetic field by the magnetic particle is easily detected. Thus, the output with high signal intensity corresponding to the magnetic field can be obtained.

Further, not only when a single magnetic particle is fixed to the surface of the FG sensor element, but also when a plurality of magnetic particles are fixed to the surface of the FG sensor element, the magnetic field of the magnetic particles can be detected by narrowing down the region to which the magnetic particles are fixed. Further, even when the detection object substance is not magnetized with a static magnetic field, the magnetic particle is fixed to the detection object substance and the fixed magnetic particle is detected, whereby when the detection object substance is indirectly detected, the aforementioned detection principle by the FG sensor of the present embodiment is effective.

According to the magnetic detection element and detecting method of the present invention, detection intensity for the magnetic field by the magnetic particle can be increased when a magnetic particle or a nonmagnetic substance labeled with a magnetic particle is detected.

Further, the magnetic detection element according to the present invention may adopt the constitution which solves the above described problems by including the magnetic substance, and the detecting coil for detecting the magnetic field received by the magnetic substance, and adding the following characteristic to the surface of the magnetic substance in the detecting coil.

More specifically, the first region and the second region are included in the longitudinal direction of the detecting coil, and the surface properties of the first region and the second region are made to differ from each other. Differing in the surface property means that the affinities with the magnetic particle which is the detection object substance differ from each other, for example. If only the region is divided into a region to which the detection object substance easily adheres and a region to which the detection object substance hardly adheres as a result, the difference may be the difference in the surface property based on the difference of a coarse surface and a surface with high flatness.

(Example 1)

In an example, an immunosensor using the magnetic detection element and detecting method of the present invention will be described.

(i) Sensor mechanism

In the present example, the FG sensor element described with FIG. 2 is used. As illustrated in FIG. 2, the FG sensor element has the exciting conductor 1231, the magnetic film 1200 formed into a cylindrical shape around the exciting conductor 1231, and the detecting coil 1220 provided in such a form as to surround the magnetic film 1200.

The producing method of the FG sensor element of the present example will be briefly described. The magnetic film 1200 made of an Ni80 permalloy as the material is formed around the exciting conductor 1231 made of Mo as the material. A nonmagnetic insulating material such as $SiO_2$ is formed on the surface of the magnetic film 1200. Further, the detecting coil 1220 made of copper as the material is provided around the nonmagnetic insulating material covering the magnetic film 1200.

Before the above describe coil is provided, the element surface is divided with the section dividing the detecting coil 1220 into two in the lengthwise direction as the boundary, and one of them is set as the first region, whereas the other one is set as the second region. The first region corresponds to the region 1301 illustrated in FIG. 1, and the second region corresponds to the region 1302 illustrated in FIG. 2. Here, a gold film is formed on a part (in the vicinity of one end of the detecting coil in FIG. 2) of the first region as the magnetic particle fixing film 1202. An SiN film is formed as the magnetic particle non-fixing film 1203 on a part (in the vicinity of the other end of the detecting coil in FIG. 2) of the second region.

After the FG sensor element is produced as described above, the alternating-current power supply 1502 illustrated in FIG. 11 is connected to an Mo line of the exciting conductor 1231.

(ii) Magnetic particle fixation

The constitution of the detection object substance will be described. FIG. 10 is a view illustrating a constitution example of the detection object substance of the present example. As illustrated in FIG. 10, the detection object substance has an antigen 1403 corresponding to the non-magnetizable substance, the magnetic particle 1401, and a secondary antibody 1404 for connecting the antigen 1403 and the magnetic particle 1401. The antigen 1403 is connected to the magnetic particle fixing film 1202 of the FG sensor element via a primary antibody 1402. Thereby, the detection object substance is fixed to the magnetic particle fixing film 1202.

By using the aforementioned magnetic detection element, a prostate-specific antigen (PSA) which is known as the marker of prostatic cancer can be tried in accordance with the following protocol. The primary antibody which recognizes PSA is fixed to the magnetic film 1200 of the FG sensor element.

(1) Phosphate buffered saline (specimen solution) including PSA which is an antigen (specimen) is injected into a flow pass and incubated for five minutes.
(2) The phosphate buffered saline is passed inside the flow pass to remove unreacted PSA.
(3) Phosphate buffered saline including an anti-PSA antibody (secondary antibody) labeled with the magnetic particle 1401 is injected into the flow pass and incubated for five minutes.
(4) An unreacted labeled antibody is cleaned with phosphate buffered saline.

By the above described protocol, the magnetic particle 1401 is fixed to the magnetic particle fixing film 1202 of the first region set on the surface of the magnetic film 1200 of the FG sensor element via the anti-PSA antibody (secondary antibody) 1404, the antigen 1403 and the primary antibody 1402. Specifically, when the antigen 1403 does not exist in the specimen, the magnetic particle 1401 is not fixed to the magnetic film 1200 part of the FG element, and therefore, it can be detected whether the antigen exists or not by detecting the presence or absence of the magnetic particle 1401.

(iii) Measurement procedures

An external magnetic field is applied in the direction perpendicular to the film surface of the magnetic film 1200, which is the magnetic field in the direction in which detection is difficult for the FG sensor element. In this manner, magnetization of the magnetic particle 1401 fixed to the magnetic particle fixing film 1202 of the first region is aligned to direct in the direction perpendicular to the film surface. By operating the alternating-current power supply 1502 illustrated in FIG. 11, an alternating magnetic field of 1 MHz is generated in the exciting conductor 1231, and the alternating magnetic field is applied to the magnetic film 1200. The induced electromotive force which occurs to the detecting coil 1220 is measured according to a detection signal indicating a potential difference occurring to both ends of the detecting coil.

Presence or absence of the magnetic particle 1401 is detected according to the presence or absence of the detection signal. From the value of the difference between the phase of the alternating magnetic field and the phase of the output, the quantity of the fixed magnetic particle 1401 is estimated, and the quantity of the antigen 1403 included in the specimen can be indirectly known. The concentration can be estimated from the quantity of the antigen 1403. When accurate application of a static magnetic field to the axis in the direction in which detection is difficult, in the setting of an experiment, the signal outputs before and after the magnetic particle 1401 is fixed are compared, and the signal output when the magnetic particle 1401 is fixed is checked in advance.

In the present example, the case where only one flow pass is formed is described in the above described (ii), but the detection part having a plurality of flow passes is adopted, and different antigen-antibody reactions are caused in the respective flow passes, whereby a plurality of antigens can be detected at one time.

(Example 2)

The present example is the application of the constitution described with FIG. 7 to the element of example 1.

As illustrated in FIG. 7, in the FG sensor element of the present example, the detecting coils 1205, 1206, 1207 and 1208 which are in the form of the coils wounded reversely from each other being connected in series are provided in the FG sensor element of example 1. The regions 1303 and 1304 illustrated in FIG. 6 are set on the surface of the magnetic film 1200. On the magnetic film 1200 at the connecting portions of the four coils connected in series and the end portions of the coils, the regions 1303 and the regions 1304 are alternately provided from the end portion of the coil.

The magnetic particle fixing film 1202 is formed on at least a part of the region corresponding to the region 1303, and the magnetic particle non-fixing film 1203 is formed on at least a part of the region corresponding to the region 1304. When the magnetic field by the magnetic particle is measured, the magnetic field by the magnetic particle 1401 fixed to the magnetic particle fixing film 1202 is detected. The magnetic particle fixation and measurement procedures are similar to example 1, and therefore, the detailed description thereof will be omitted.

The FG sensor element described in the above described examples 1 and 2 are not limited to the ones having the above described structures, and orthogonal FG sensors element of the other structures may be used.

This application claims the benefit of Japanese Patent Application No. 2007-179635, filed July 9, 2007, which can be used as further reference.

**Claims**

1.  A magnetic detection element, comprising:

    an exciting conductor (1231);
    a magnetic substance (1200) which is provided around the exciting conductor and to which an alternating magnetic field ($H_{AC}$) is applied from the exciting conductor; and
    a detecting coil (1210) for detecting a magnetic field received by the magnetic substance,
    **characterized in that**
    a surface of the magnetic substance comprises a first region (1301) and a second region (1302), arranged in a longitudinal direction of the detecting coil, and affinities for a detection object substance (1401-1404) differ between the first region and the second region.

2.  The magnetic detection element according to claim 1, wherein
    the detecting coil comprises two or more coils (1211-1214) connected in series with winding directions of the coils being reversed for adjacent coils; and
    the surface of the magnetic substance comprises a plurality of the first regions and the second regions which are alternately provided on a surface of the magnetic substance at positions corresponding to connecting portions of the two or more coils and both end portions of the detecting coil.

3.  The magnetic detection element according to claims 1 or 2, wherein on at least a part of the first region, a film (1202) comprised of a nonmagnetic material is provided with a high affinity for the detection object substance as compared with the second region.

4.  The magnetic detection element according to claim 3, wherein the affinity for the detection object substance of the first region is controlled by a flatness of the surface or by a hydrophilic property, thickness, or composition of the film.

5. A detecting method using the magnetic detection element according to any one of claims 1 to 4, comprising:

fixing the detection object substance to a surface of the magnetic detection element;
applying a static magnetic field for setting a magnetization direction of the detection object substance; and
applying an alternating magnetic field to the magnetic substance, and measuring an intensity of a signal generated in the detecting coil with the magnetic detection element to detect presence or absence or a concentration of the detection object substance.

6. The detecting method according to claim 5, wherein a magnetic field direction of the static magnetic field is in a normal line direction to a tangent plane at a position where the detection object substance is fixed to the magnetic detection element.

7. The detecting method according to claims 5 or 6, wherein the detection object substance includes
a non-magnetizable substance (1402-1404), and
a magnetic particle (1401) which is fixed to the non-magnetizable substance.

8. The detecting method according to claim 7, wherein the non-magnetizable substance is a biological substance.

9. The detecting method according to claims 5 or 6, wherein the detection object substance is a magnetic substance.


**Patentansprüche**

1. Magnetisches Nachweiselement, umfassend:

einen Anregungsleiter (1231);
eine magnetische Substanz (1200), die um den Anregungsleiter herum vorgesehen ist, und auf die seitens des Anregungsleiters ein magnetisches Wechselfeld ($H_{AC}$) aufgebracht wird; und
eine Nachweisspule (1210) zum Nachweisen eines von der magnetischen Substanz aufgenommenen Magnetfelds,
**dadurch gekennzeichnet, dass**
eine Fläche der magnetischen Substanz eine erste und eine zweite Zone (1301 bzw. 1302) umfasst, welche angeordnet sind in einer Längsrichtung der Nachweisspule, wobei Affinitäten für eine Objektnachweissubstanz (1401-1404) zwischen der ersten und der zweiten Zone unterschiedlich sind.

2. Nachweiselement nach Anspruch 1, wobei
die Nachweisspule zwei oder mehr Spulen (1211-1214) in Reihenschaltung umfasst, wobei die Wicklungsrichtungen der Spulen für benachbarte Spulen umgekehrt sind; und
die Fläche der magnetischen Substanz mehrere erste und zweite Zonen umfasst, welche alternierend vorgesehen sind auf der Fläche der magnetischen Substanz an Positionen, die den Verbindungsabschnitten der zwei oder mehr Spulen und beiden Endabschnitten der Nachweisspule entsprechen.

3. Nachweiselement nach Anspruch 1 oder 2, wobei
an zumindest einem Teil der ersten Zone eine Schicht (1202) aus einem nicht-magnetischen Werkstoff mit einer hohen Affinität für die Objektnachweissubstanz, verglichen mit der zweiten Zone, vorgesehen ist.

4. Nachweiselement nach Anspruch 3, wobei
die Affinität für die Objektnachweissubstanz der ersten Zone gesteuert wird vom Ebenheitsgrad der Fläche oder von einer hydrophilen Eigenschaft, von der Dicke oder von der Schichtzusammensetzung.

5. Nachweisverfahren unter Verwendung des magnetischen Nachweiselements nach einem der Ansprüche 1 bis 4, umfassend:

Fixieren der Objektnachweissubstanz an einer Fläche des magnetischen Nachweiselements;
Anlegen eines statischen Magnetfelds zur Einstellung einer Magnetisierungsrichtung der Objektnachweissubstanz; und

Anlegen eines magnetischen Wechselfelds an die magnetische Substanz und Messen der Stärke eines in der Nachweisspule erzeugten Signals mit dem magnetischen Nachweiselement, um das Vorhandensein oder Fehlen oder eine Konzentration der Objektnachweissubstanz nachzuweisen.

6. Nachweisverfahren nach Anspruch 5, wobei
eine Magnetfeldrichtung des statischen Magnetfelds die Normalen-Richtung auf einer Tangentialebene an einer Position ist, an welcher die Objektnachweissubstanz am magnetischen Nachweiselement fixiert ist.

7. Nachweisverfahren nach Anspruch 5 oder 6, wobei
die Objektnachweissubstanz beinhaltet:

eine nicht-magnetisierbare Substanz (1402-1404), und
ein magnetisches Partikel (1401), welches an der nichtmagnetisierbaren Substanz fixiert ist.

8. Nachweisverfahren nach Anspruch 7, wobei die nicht-magnetisierbare Substanz eine biologische Substanz ist.

9. Nachweisverfahren nach Anspruch 5 oder 6, wobei die Objektnachweissubstanz eine magnetische Substanz ist.


**Revendications**

1. Élément de détection magnétique, comprenant :

un conducteur d'excitation (1231) ;
une substance magnétique (1200) qui est disposée autour du conducteur d'excitation et à laquelle un champ magnétique alternatif ($H_{AC}$) est appliqué par le conducteur d'excitation ; et
une bobine de détection (1210) pour détecter un champ magnétique reçu par la substance magnétique, **caractérisé en ce que**
une surface de la substance magnétique comprend une première région (1301) et une seconde région (1302) disposées dans une direction longitudinale de la bobine de détection et **en ce que** les affinités vis-à-vis d'une substance objet de la détection (1401-1404) diffèrent entre la première région et la seconde région.

2. Élément de détection magnétique selon la revendication 1, dans lequel
la bobine de détection comprend deux ou plusieurs bobines (1211-1214) connectées en série, les directions d'enroulement des bobines étant inversées pour des bobines adjacentes ; et
la surface de la substance magnétique comprend une pluralité de premières régions et de secondes régions qui sont disposées en alternance sur une surface de la substance magnétique à des positions correspondant à des parties de connexion des deux bobines ou plus et des deux parties d'extrémité de la bobine de détection.

3. Élément de détection magnétique selon la revendication 1 ou 2, dans lequel, sur au moins une partie de la première région, un film (1202) constitué d'un matériau non magnétique est doté d'une affinité élevée vis-à-vis de la substance objet de la détection par comparaison à la seconde région.

4. Élément de détection magnétique selon la revendication 3, dans lequel l'affinité vis-à-vis de la substance objet de la détection de la première région est régulée par la planéité de la surface ou par une propriété hydrophile, l'épaisseur ou la composition du film.

5. Procédé de détection utilisant l'élément de détection magnétique selon l'une quelconque des revendications 1 à 4, comprenant :

la fixation de la substance objet de la détection à une surface de l'élément de détection magnétique ;
l'application d'un champ magnétique statique permettant de fixer une direction de magnétisation de la substance objet de la détection ; et
l'application d'un champ magnétique alternatif à la substance magnétique et la mesure d'une intensité d'un signal généré dans la bobine de détection à l'aide de l'élément de détection magnétique pour détecter la présence ou l'absence d'une concentration de la substance objet de la détection.

6. Procédé de détection selon la revendication 5, dans lequel la direction de champ magnétique du champ magnétique statique est une direction rectiligne normale à un plan tangent en une position à laquelle la substance objet de la détection est fixée à l'élément de détection magnétique.

7. Procédé de détection selon la revendication 5 ou 6, dans lequel la substance objet de la détection comprend :

   une substance non magnétisable (1402-1404), et
   une particule magnétique (1401) qui est fixée à la substance non magnétisable.

8. Procédé de détection selon la revendication 7, dans lequel la substance non magnétisable est une substance biologique.

9. Procédé de détection selon la revendication 5 ou 6, dans lequel la substance objet de la détection est une substance magnétique.

## FIG. 1

## FIG. 2

## FIG. 3

14

## FIG. 4A

## FIG. 4B

FIG. 5A

FIG. 5B

FIG. 5C

FIG. 5D

## FIG. 6

## FIG. 7

## FIG. 8

## FIG. 9

## FIG. 10

# FIG. 11

1502

1204

Hext

2000

1231

1200

# FIG. 12A

# FIG. 12B

# FIG. 12C

## FIG. 13A

## FIG. 13B

## FIG. 14A

## FIG. 14B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2005315744 A
- JP 2006208368 A
- JP 2007179635 A

### Non-patent literature cited in the description

- **H. A. FERREIRA et al.** *J. Appl. Phys.,* 2003, vol. 93, 7281
- **PIERRE-A. BESSE et al.** *Appl. Phys. Lett.,* 2002, vol. 80, 4199
- **SEUNGKYUN LEE et al.** *Appl. Phys. Lett.,* 2002, vol. 81, 3094
- **RICHARD LUXTON et al.** *Anal. Chem.,* 2001, vol. 16, 1127
- **HORIA CHIRIAC et al.** *J. Magn. Magn. Mat.,* 2005, vol. 293, 671
- *The Transactions of the Institute of Electrical Engineers of Japan C,* 1973, vol. 93-C (2), 27
- Foundation and Application of Electromagnetics. Magnetics Technical Committee. Institute of Electrical Engineers of Japan, 171
- Magnetics Technical Committee. Institute of Electrical Engineers of Japan, 171